# EUROPEAN PATENT APPLICATION

(11) **EP 4 089 907 A1**
(43) Date of publication of application: **16.11.2022**
(21) Application number: 21173065.0
(22) Date of filing: 10.05.2021
(51) Int. Cl.: H02M 7/00, H02M 7/493

(54) **THREE-PHASE INVERTER POWER MODULE AND THREE-PHASE INVERTER POWER DEVICE**

(71) Applicant: Hitachi Energy Switzerland AG, 5400 Baden (CH)
(72) Inventor: HARTMANN, Samuel, 5603 Staufen (CH)
(74) Representative: Epping - Hermann - Fischer

(57) **Abstract**

A three-phase inverter power module (40) is specified, comprising at least two separated six-pack submodules (28, 29, 30), wherein:
- each six-pack submodule (28, 29, 30) comprises at least one half-bridge subunit per phase,
- each half-bridge subunit comprises an internal positive direct current, DC, terminal, an internal negative DC terminal and an internal alternating current, AC, terminal, and
- the separated six-pack submodules (28, 29, 30) are electrically coupled with each other in parallel.

## Description

The present disclosure relates to a three-phase inverter power module and a three-phase inverter power device.

Low loss and low cost are increasingly important for three-phase inverter power modules in automotive and/or other applications. Electric losses are costs which either need to be paid via an electricity bill or for example, by using larger batteries in an electric car. Electric loss and cost are in a trade-off relation. More money may be spent to obtain better power electronics with lower electric losses.

One way to lower electric losses may be to switch the three-phase inverter faster. However, when switching faster, a higher overvoltage is generated by a commutation loop inductance, which consequently leads to overvoltage. As a consequence, a direct current, DC, voltage of the three-phase inverter needs to be reduced according to the invention in order to provide sufficient safety within a blocking capability of the switches of the three-phase inverter. Furthermore, in this regard, a capability of an electrical isolation should be considered. At a lower DC voltage, the performance of the three-phase inverter and/or the total system may be reduced.

Embodiments of the disclosure address in whole or in part the above shortcomings by a three-phase inverter power module which has an improved performance and decreased electrical losses, and a three-phase inverter power device having such a three-phase inverter power module.

The exemplary embodiment of the disclosure addresses the above shortcomings by the subject-matter of the independent claims. Further exemplary embodiments are evident from the dependent claims and the following description.

A first aspect relates to a three-phase inverter power module.

The term "power" here and in the following, for example, refers to three-phase inverter power modules and three-phase inverter power devices adapted for processing voltages and currents of more of 100 V and/or more than 10 A. For example, power may refer to a voltage and/or to a current and/or to a product of the voltage and the current. The voltage and/or the current may, exemplarily, be a load voltage and/or a load current, an input voltage and/or an input current, or an output voltage and/or an output current of such a power module.

For example, the three-phase inverter power module may be used in automotive applications, such as electric vehicles, hybrid vehicles, motorbikes, buses, trucks, off-road construction vehicles and charging stations. Furthermore, the three-phase inverter power module may also be applicable for other applications.

With regard to the following description, a module which is comprised in a further module may be denoted as a submodule or subunit of that module. For example, such a submodule is not an individual module. Accordingly, a terminal of the module which is comprised in the further module may be denoted as connection and/or internal connection and/or internal terminal. Accordingly, a terminal of the further module may be denoted as external terminal.

According to the embodiment of the first aspect, the three-phase inverter power module according to the first aspect comprises at least two separated six-pack submodules.

According to the embodiment, each six-pack submodule comprises at least one half-bridge subunit per phase.

According to the embodiment, each half-bridge subunit comprises an internal positive direct current, DC, terminal, an internal negative DC terminal and an internal alternating current, AC, terminal. The internal AC terminal may also be denoted as output terminal.

According to the embodiment, the separated six-pack submodules are electrically coupled with each other in parallel.

The term "comprises/comprising" with respect the three-phase inverter power module comprising one or more six-pack submodules, refers to an electrical and a functional definition. Therefore, six-pack submodules comprised in the three-phase inverter power module are no individual modules, but may also be denoted as respective submodules or subunits of the three-phase inverter power module.

The term "comprises/comprising" with respect the six-pack submodule comprising one or more half-bridge modules or subunits, refers to an electrical and a functional definition. Therefore, half-bridge modules or subunits comprised in the respective six-pack submodules are no individual modules, but may also be denoted as respective submodules or subunits of the respective six-pack submodule.

For example, the half-bridge subunits may be allocated on separate substrates.

By electrically coupling the separated six-pack submodules with each other in parallel, all half-bridge subunits of the same phase are electrically coupled with each other in parallel.

Therefore, multiple paralleled six-pack submodules are integrated into a single module. Conventional six-pack modules may be formed by using separated half-bridge subunits. For example, a conventional half-bridge submodule may comprise semiconductor chips electrically coupled in series forming high side and low side devices. In this case, there may be several paralleled semiconductor chips per high side and per low side. However, according to the first aspects and its embodiments, paralleled semiconductor chips of individual switches of the half-bridge subunits of the three-phase inverter power module are evenly distributed within the power module. In this way, a current slope during a commutation of one or more half-bridges is also distributed evenly to all pairs of internal positive DC terminals and internal negative DC terminals of all half-bridge subunits. Thus, a commutation loop inductance of the three-phase inverter power module may be lowered by up to 20 percent, compared to conventional three-phase inverters.

According to at least one embodiment of the three-phase inverter power module, the three-phase inverter power module comprises one or more external positive DC terminals. The one or more external positive DC terminals are electrically coupled with the respective internal positive DC terminals of all separated half-bridge subunits. The three-phase inverter power module further comprises one or more external negative DC terminals. The one or more external negative DC terminals are electrically coupled with the respective internal negative DC terminals of all separated half-bridge subunits.

For example, the one or more external positive DC terminals of the three-phase inverter power module are electrically coupled with the internal positive DC terminals of all separated half-bridge subunits by a positive DC bus bar.

For example, the one or more external negative DC terminals of the three-phase inverter power module are electrically coupled with the internal negative DC terminals of all separated half-bridge subunits by a positive DC bus bar.

According to at least one embodiment of the three-phase inverter power module, the three-phase inverter power module comprises at least one external AC terminal per phase, which is electrically coupled with the respective internal AC terminals of all separated half-bridge subunits of the respective phase.

For example, the one or more external AC terminals of each phase of the three-phase inverter power module are electrically coupled with the internal AC terminals of the respective phase of all separated half-bridge subunits by AC bus bars. For example, the three-phase inverter power module comprises three AC bus bars, i.e., one for each phase.

According to the embodiment the three-phase inverter power module comprises at two external AC terminals per phase.

According to at least one embodiment of the three-phase inverter power module, the three-phase inverter power module comprises at least two external positive DC terminals.

According to at least one embodiment of the three-phase inverter power module, the three-phase inverter power module comprises at least two external negative DC terminals.

According to at least one embodiment of the three-phase inverter power module, the three-phase inverter power module comprises at least k external positive DC terminals and k+1 external negative DC terminals, wherein k is an integer and k >= 1.

In this way, the three-phase inverter power module may be provided in symmetrical structure. Such a symmetric structural arrangement or a kind of coaxial arrangement of terminals reduces a stray inductance of a terminal setup comprising the respective terminals.

According to at least one embodiment of the three-phase inverter power module, the three-phase inverter power module comprises at least j external negative DC terminals and j+1 external positive DC terminals, wherein j is an integer and j >= 1.

In this way, the three-phase inverter power module may be provided in symmetrical structure. Such a symmetric structural arrangement or a kind of coaxial arrangement of terminals reduces a stray inductance of a terminal setup comprising the respective terminals.

According to at least one embodiment of the three-phase inverter power module, the external positive DC terminals and the external negative DC terminals are provided on a first lateral side of the three-phase inverter power module. The external AC terminals are provided on a second lateral side of the three-phase inverter power module.

The first lateral side is different from the second lateral side. For example, the second lateral side is opposite the first lateral side.

In this way, the three-phase inverter power module comprises a DC side and an AC side, which are different from each other, i.e., they may be opposite. Thereby, exemplarily, a process of providing connections to the respective external terminals may be simplified and a wiring effort may be minimized for a user of the three-phase inverter power module.

According to at least one embodiment of the three-phase inverter power module, the three-phase inverter power module comprises at least three separated six-pack submodules.

Therefore, the load may be evenly shared between the three separated six-pack submodules. Thus, the commutation loop inductance of the three-phase inverter power module may be reduced to one third compared to a conventional three-phase inverter.

This is due to a terminal inductance contributing to the commutation loop inductance being reduced to one third. A reduction of a stray inductance is only valid if the three half-bridge subunits are not commutating simultaneously. This must be ensured by a control algorithm. In low inductance set-ups the terminal inductance typically contributes to 30% of the total inductance. If this can be reduced to 10%, the total inductance is reduced from 100% to 80%. Thus, a 20% reduction of total commutation loop inductance can be achieved.

According to at least one embodiment of the three-phase inverter power module, each half-bridge subunit comprises two semiconductor chips formed as switches. The three-phase inverter power module comprises a (external) control terminal, which is configured to obtain signals for controlling the switches of the half-bridge subunits.

The two semiconductor chips formed as switches of each half-bridge subunit may form high side and low side devices. A device may comprise one or more semiconductor chips. One or more semiconductor chips may form a switch.

The two semiconductor chips of each half-bridge subunit may be paralleled. Therefore, a current sharing and/or current distribution for the paralleled semiconductor chips may be improved. For example, each side of each half-bridge subunit may be still realized by using several parallel semiconductor chips.

The three-phase inverter power module may comprise one or more control terminals, for example, one control terminal for each switch. For example, each switch corresponds to a same phase and a same side of the respective half-bridge subunit, i.e. the high side or the low side.

Each semiconductor chip, for example, is formed of at least one of a diode and/or a switch. The semiconductor chip is, exemplarily, a transistor, a varistor, an insulated gate bipolar transistor, IGBT for short, or a metal oxide semiconductor field-effect transistor, MOSFET for short, or a metal insulator semiconductor field-effect transistor, MISFET for short, or any other arbitrary power semiconductor device, i.e., a Gallium nitride HEMT or the like. For example, for a silicon carbide MOSFET, diodes are not needed.

For example, the one or more control terminals may be used to control a gate terminal of the respective switch. Additionally, the one or more control terminals may have functionality of a probe or may be used to control further terminals of the respective switch, i.e., an auxiliary emitter and/or an auxiliary source and/or an auxiliary collector and/or an auxiliary drain. The control function of the one or more control terminal may be dependent on a type of semiconductor chip used.

For example, the three-phase inverter power module is arranged, so that all paralleled chips have a similar and/or same path length to one closest external positive DC terminals and/or to one closest external negative DC terminal. For example, all paralleled chips have a same path length to all external positive DC terminals and to all external negative DC terminals. For example, all paralleled chips have a same path length to all external AC terminals, i.e., to all output terminals.

The term "same" with respect to the path length may be a target for homogenization of switching. However, the path length may be relatively the same, as an exact same path length may not be realizable in production.

In this way, for example, if each semiconductor chip is an IGBT, a same inductive voltage drop applies to all source potentials of the paralleled chips during a turn-on of the respective switch and/or switches. For example, the commutation loop inductance may cause an overvoltage during switching. Therefore, a reduced commutation loop inductance is consequently needed for fast switching. The overvoltage may be similar in case of same or at least similar path length.

According to at least one embodiment of the three-phase inverter power module, the three-phase inverter power module comprises a multi-layer printed circuit board, PCB. The multi-layer PCB comprises two or more layers. Furthermore, the multi-layer PCB is electrically connected to the control terminal.

Alternatively, the three-phase inverter power module may comprise different means for an interconnection which is connected to the one or more control terminals.

For example, the multi-layer PCB is electrically connected to the one or more control terminals.

For example, if the switches are IGBTs and/or MOSFETs, the multi-layer PCB may comprise control terminals and/or auxiliary terminals for the respective gates and/or emitters and/or collectors of the respective IGBT and/or for the respective drain and/or source of the respective MOSFET.

For example, the multi-layer PCB may be provided, so that the conductor tracks on the multi-layer PCB may have a low and homogenized Inductance. This may be achieved by parallel routing of gate connections for the switches of the half-bridge subunits and/or gate terminals for the switches of the half-bridge subunits and/or auxiliary emitters for the switches of the half-bridge subunits, alternation of layers or the like, when the multi-layer PCB is designed. Such an alternation of layers and/or flipping of gate connection and auxiliary emitter connection may be used for a reduction or an enhancement of the commutation loop inductance. Hence it may be applied especially for adjustment and/or homogenization. For example, when positioning the conductor tracks on the multi-layer PCB an adjustment or homogenization of the inductances, resulting in homogenous switching, may be made regarding the positioning of the conductor track with respect to each other, exemplarily, in case of multiple gates by respectively arranging and/or routing a respective gate connection with respect to a respective auxiliary emitter connection. For example, the gate connections, i.e. gate conductor tracks, should also have a same path length. For example, the multi-layer PCB may comprise gate resistors for the switches of the half-bridge subunits. By using a parallel routing of the gate connections, i.e. gate conductor tracks, and the auxiliary emitters connections, the inductivity may be reduced.

According to at least one embodiment of the three-phase inverter power module, the control terminal is provided on a third lateral side of the three-phase inverter power module.

For example, the third lateral side may be the first lateral side or the second lateral side.

Alternatively, for example, the third lateral side is perpendicular to the first lateral side and the second lateral side.

Thereby, exemplarily, a process of providing connections to the respective external terminals may be simplified and a wiring effort may be minimized for a user of the three-phase inverter power module. For example, the internal wiring of the module may be more difficult, however the external wiring for the user may be easier.

According to at least one embodiment of the three-phase inverter power module, the three-phase inverter power module comprises at least two parallel substrates. Each substrate comprises all three phases of the respective six-pack submodule. The three phases of the respective substrate are arranged in parallel.

For example, the three-phase inverter power module comprises one substrate for each six pack module.

According to at least one embodiment of the three-phase inverter power module, the three-phase inverter power module comprises at least two groups of chips. Each group of chips comprises all three phases of the respective six-pack submodule. The three phases of the respective group of chips are arranged in parallel.

According to at least one embodiment of the three-phase inverter power module, the three-phase inverter power module comprises a common housing.

For example, the housing surrounds the substrates. The housing may comprise one or more load terminal and/or gate signal terminal and/or additional control terminals.

A second aspect relates to a three-phase inverter power device. According to the embodiment of the second aspect, the three-phase inverter power device comprises at least one three-phase inverter power module described herein above. All features disclosed in connection with the three-phase inverter power module are therefore also disclosed in connection with the power semiconductor device and vice versa.

The solution according to the first aspect and the embodiments of the first aspect is to integrate a number of paralleled six pack into one module, i.e., the three-phase inverter power. Electrically paralleled six-pack submodules, each six-pack submodule comprising three parallel half-bridge sub-submodules or subunits, are integrated into this one module. They are separated from each other in the module. However, these six-pack submodules and half-bridge sub-submodules or subunits are not individual modules. Moreover, they are functionally comprised in the three-phase inverter power module.

The subject-matter of the disclosure will be explained in more detail in the following with reference to exemplary embodiments which are illustrated in the attached drawings.
Figure 1 schematically shows a circuit diagram of a conventional half-bridge module.
Figure 2 schematically shows a conventional three-phase inverter consisting of three individual half-bridge modules.
Figures 3 schematically shows a conventional six-pack module.
Figure 4 schematically shows a further conventional three-phase inverter.
Figures 5 and 6 each schematically show a three-phase inverter power module according to an exemplary embodiment.
Figure 7 schematically shows a layout of a three-phase inverter power module 40 to an exemplary embodiment.

The reference symbols used in the drawings, and their meanings, are listed in summary form in the list of reference symbols. In principle, identical parts are provided with the same reference symbols in the figures. It is to be understood that the embodiments shown in the drawings are illustrative representations and are not necessarily drawn to scale.

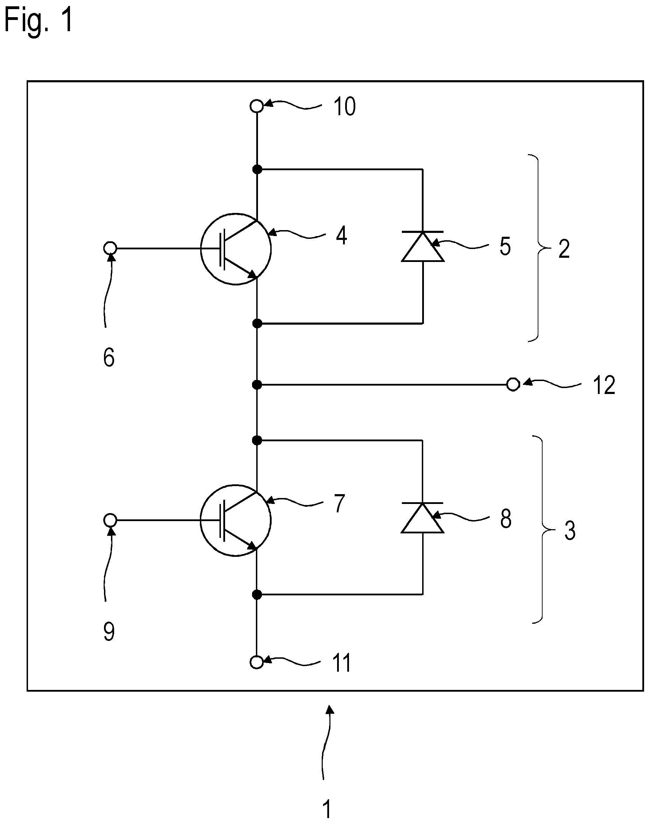

The conventional half-bridge module 1 of Figure 1 comprises a first leg 2 and a second leg 3. The half-bridge module 1 may also be denoted as phase-leg. The first leg 2 comprises a first switch 4, a first free wheeling diode 5 electrically antiparallel coupled to the first switch 4 and a first switch terminal 6. The first leg 2 may also be denoted as high side. The first switch terminal 6 is configured to control a state of the first switch 4. For example, the first switch terminal 6 is a gate terminal of the first switch 4. The second leg 3 comprises a second switch 7, a second free wheeling diode 8 electrically antiparallel coupled to the second switch 7 and a second switch terminal 9. The second leg 3 may also be denoted as low side. For example, the second switch terminal 9 is a gate terminal of the second switch 7. The second switch terminal 9 is configured to control a state of the second switch 7. The first switch 4 and the second switch 7 are electrically coupled in series.

The first switch 4 and the second switch 7 each are, exemplarily, a transistor, an insulated gate bipolar transistor, IGBT for short, or a metal oxide semiconductor field-effect transistor, MOSFET for short, or a metal insulator semiconductor field-effect transistor, MISFET for short, or another type of switching device. During a normal operation state, none or one of but not both the first switch 4 and the second switch 7 are switched on at a same time.

Depending on a type of the first switch 4 and/or the second switch 7, the first free wheeling diode 5 and/or the second free wheeling diode 8 may be omitted.

Furthermore, the half-bridge module 1 comprises a positive direct current, DC, terminal 10, a negative DC terminal 11 and an alternative current, AC, terminal 12. The AC terminal 12 may also be denoted as phase terminal and/or may also be denoted as output terminal.

For example, the half-bridge module 1 may be used to connect an electric potential of the positive DC terminal 10 or an electric potential of the negative DC terminal 11 to the AC terminal 12 and/or, exemplarily, a load connected therewith.

For example, instead of just one switch and one free wheeling diode, the first leg 2 and/or the second leg 3 may comprise more than one switch and/or more than one free wheeling diode. In this way, an ampacity and/or a current capability may be improved.

If the half-bride module 1 is comprised in another module or submodule, it may be denoted as half-bridge subunit 1.

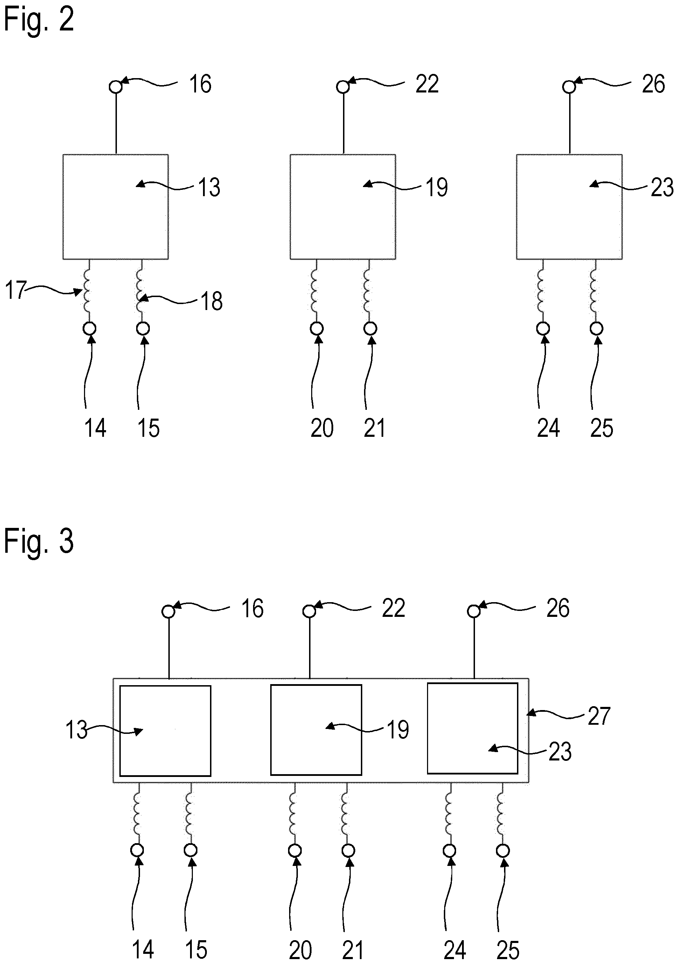

The conventional three-phase inverter of Figure 2 comprises a first half-bridge module 13. The first half-bridge module 13 comprises a first positive DC terminal 14, a first negative DC terminal 15 and a first AC terminal 16. The first positive DC terminal 14 comprises a first inductance 17. The first negative DC terminal 15 comprises a second inductance 18.

The conventional three-phase inverter further comprises a second half-bridge module 19. The second half-bridge module 19 comprises a second positive DC terminal 20, a second negative DC terminal 21 and a second AC terminal 22.

The conventional three-phase inverter further comprises a third half-bridge module 23. The third half-bridge module 23 comprises a third positive DC terminal 24, a third negative DC terminal 25 and a second AC terminal 26.

Similar to the first half-bridge module 13, the second half-bridge module 19 and the third half-bridge module 23 comprise respective inductances for their respective DC terminals 20, 21, 24, 25, which are not denoted by reference symbols in order to facilitate the understanding of the drawings.

The first half-bridge module 13, the second half-bridge module 19 and the third half-bridge module 23 may be constructed according to the half-bridge module 1 as discussed with respect to Figure 1. The conventional three-phase inverter use one of the three half-bridge modules 13, 19, 23 per phase, i.e., the first half-bridge module 13 for a first AC phase, the second half-bridge module 19 for a second AC phase and the third half-bridge module 23 for a third AC phase.

For example, when the conventional three-phase inverter is operated so that a commutation takes place, one of the respective phases is switched from an electric potential at its positive DC terminal to an electric potential at its negative DC terminal. Thereby, a commutation loop is formed, which comprises the respective positive DC terminal and the respective negative DC terminal of the respective half-bridge module. Therefore, the inductances of the respective half-bridge module contribute to a commutation loop inductance. The commutation loop inductance is partly provided by a stray inductance of respective positive DC terminals and respective negative DC terminals.

The conventional six-pack module 27 according to Figure 3 comprises the first half-bridge module 13, the second half-bridge module 19 and the third half-bridge module 23, as discussed with respect to Figure 2. The first half-bridge module 13, the second half-bridge module 19 and the third half-bridge module 23 of the six-pack module 27 are electrically connected in parallel with respect to their positive DC terminals 14, 20, 24 and their negative DC terminals 15, 21, 25.

The term "comprises/comprising" with respect the six-pack module 27 according to Figure 3 comprising the first half-bridge module 13, the second half-bridge module 19 and the third half-bridge module 23, refers to an electrical and a functional definition. Therefore, according to Figure 3, the first half-bridge module 13, the second half-bridge module 19 and the third half-bridge module 23 are no individual modules, but may also be denoted as respective submodules or subunits of the six-pack module 27, i.e. the first half-bridge subunit 13, the second half-bridge subunit 19 and the third half-bridge subunit 23.

For example, the first half-bridge module 13, the second half-bridge module 19 and the third half-bridge module 23 are comprised in a same housing of the conventional six-pack module 27.

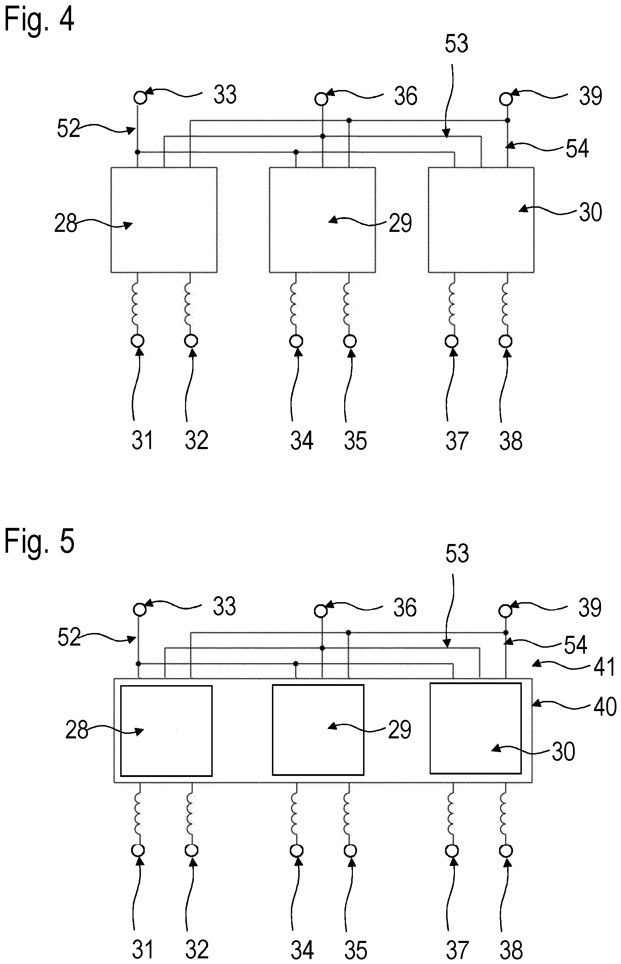

The conventional three-phase inverter according to Figure 4 comprises a first six-pack module 28, a second six-pack module 29 and a third six-pack module 30.

According to Figure 4, the six-pack module 28, second six-pack module 29 and the third six-pack module 30 are individual modules.

Each of the six-pack modules 28, 29, 30 may be constructed similar to the conventional six-pack module 27 as discussed with respect to Figure 3. However, the first six-pack module 28, the second six-pack module 29 and the third six-pack module 30 are smaller six-pack modules totalling in a same rating, with regards to their power specifications, as three half-bridge modules, such as the first half-bridge module 13, the second half-bridge module 19 and the third half-bridge module 23. For example, each of the six-pack modules 28, 29, 30 has only one third of a current capability compared to the six-pack module according to Figure 3.

The conventional three-phase inverter according to Figure 4 comprises a fourth positive DC terminal 31, a fourth negative DC terminal 32 and a fourth AC terminal 33.

As disclosed with respect to Figure 3, the first half-bridge module 13, the second half-bridge module 19 and the third half-bridge module 23 are no individual modules, but may also be denoted as respective submodules or subunits of the six-pack modules 28, 29, 30. Therefore, the terminals 14, 15, 16, 20, 21, 22, 24, 25, 26 of these submodules may also be denoted as internal terminals and/or internal connections of the respective six-pack modules 28, 29, 30.

For example, the external fourth positive DC terminal 31 is connected to the internal first positive DC terminal 14 of the first half-bridge module 13, the internal second positive DC terminal 20 of the second half-bridge module 19 and the internal third positive DC terminal 24 of the third half-bridge module 23, of the first six-pack module 28.

For example, the external fourth negative DC terminal 32 is connected to the internal first negative DC terminal 15 of the first half-bridge module 13, the internal second negative DC terminal 21 of the second half-bridge module 19 and the internal third negative DC terminal 25 of the third half-bridge module 23, of the first six-pack module 28.

For example, the external fourth AC terminal 33 is connected to the internal first AC terminal 16 of the first half-bridge module 13 of the of the first six-pack module 28, the internal first AC terminal 16 of the first half-bridge module 13 of the of the second six-pack module 29 and the internal first AC terminal 16 of the first half-bridge module 13 of the of the third six-pack module 30.

Similarly to the foregoing, the conventional three-phase inverter according to Figure 4 comprises a external fifth positive DC terminal 34, a external fifth negative DC terminal 35 and a external fifth AC terminal 36, which each comprise respective connections.

For example, the external fifth AC terminal 36 is connected to the internal second AC terminal 22 of the second half-bridge module 19 of the of the first six-pack module 28, the internal second AC terminal 22 of the second half-bridge module 19 of the of the second six-pack module 29 and the internal second AC terminal 22 of the second half-bridge module 19 of the of the third six-pack module 30.

Similarly to the foregoing, the conventional three-phase inverter according to Figure 4 comprises a external sixth positive DC terminal 37, a external sixth negative DC terminal 38 and a external sixth AC terminal 39, which each comprise respective connections.

For example, the external sixth AC terminal 39 is connected to the internal third AC terminal 26 of the third half-bridge module 23 of the of the first six-pack module 28, the internal third AC terminal 26 of the third half-bridge module 23 of the of the second six-pack module 29 and the internal third AC terminal 26 of the third half-bridge module 23 of the of the third six-pack module 30.

The first six-pack module 28, the second six-pack module 29 and the third six-pack module 30 are electrically connected in parallel. For example, they are electrically connected in parallel with respect to the external AC terminals 33, 36, 39.

The first six-pack module 28 is arranged in a first housing, the second six-pack module 29 is arranged in a second housing and the third six-pack module 30 is arranged in a third housing. Therefore, the conventional three-phase inverter according to Figure 4 is formed by using three AC bus bars 52, 53, 54, one per phase, i.e. a first AC bus bar 52, a second AC bus bar 53 and a third AC bus bar 54, which need to be externally connected to all six-pack modules 28, 29, 20. Thereby, the external AC terminals 33, 36, 39 of the conventional three-phase inverter according to Figure 4 are formed.

This constitutes a high effort with regards to wiring and/or connecting the conventional three-phase inverter according to Figure 4 for a user of the conventional three-phase inverter.

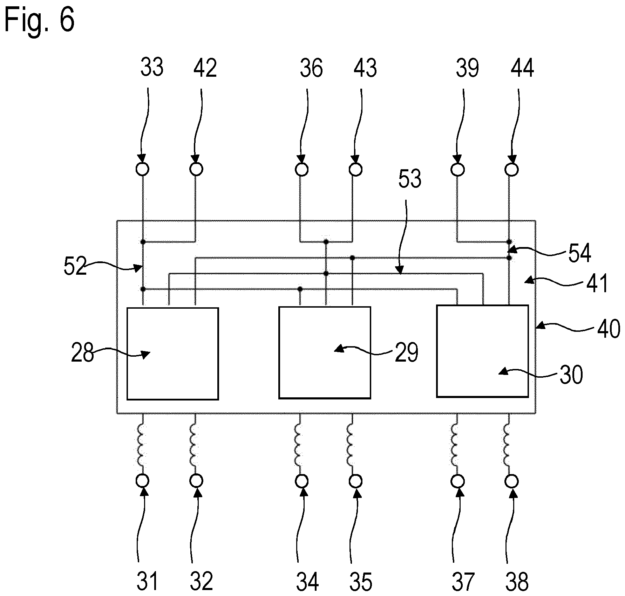

The three-phase inverter power module 40 according to the exemplary embodiment of Figures 5 and 6 comprises the first six-pack module 28, the second six-pack module 29 and the third six-pack module 30, as discussed with respect to Figure 4.

The term "comprises/comprising" with respect the three-phase inverter power module 40 according to Figures 5 and 6 comprising the first six-pack module 28, the second six-pack module 29 and the third six-pack module 30, refers to an electrical and a functional definition. Therefore, according to Figures 5 and 6, the first six-pack module 28, the second six-pack module 29 and the third six-pack module 30 are no individual modules, but may also be denoted as respective submodules of the three-phase inverter power module 40, i.e., the first six-pack submodule 28, the second six-pack submodule 29 and the third six-pack submodule 30.

In contrast to Figure 4, the first six-pack submodule 28, the second six-pack submodule 29 and the third six-pack submodule 30 are arranged together in the three-phase inverter power module 40. For example, they are arranged in a housing of the three-phase inverter power module 40.

Exemplarily, the external positive DC terminals 31, 34, 37 of the three-phase inverter power module 40 are connected by a positive DC bus bar.

Exemplarily, the external negative DC terminals 32, 35, 38 of the three-phase inverter power module 40 are connected by a negative DC bus bar.

According to the exemplary embodiment of Figure 5, the first six-pack submodule 28, the second six-pack submodule 29 and the third six-pack submodule 30 are electrically connected in parallel. For example, they are electrically connected in parallel with respect to the external AC terminals 33, 36, 39 by using AC connections 41. The AC connections 41 are arranged externally to the three-phase inverter power module 40 and may be formed by the three AC bus bars 52, 53, 54 according to the exemplary embodiment of Figure 5.

The three-phase inverter power module 40 according to the exemplary embodiment of Figure 6 further comprises the AC connections 41. In this case, the AC connections 41 are comprised in the three-phase inverter power module 40 according to the exemplary embodiment of Figure 6. For example, they are arranged in the housing of the three-phase inverter power module 40.

Exemplarily, the three-phase inverter power module 40 according to the exemplary embodiment of Figure 6 further comprises another external first AC terminal 42, another external second AC terminal 43 and another external third AC terminal 44.

For example, the AC connections 41 comprise the three AC bus bars 52, 53, 54 as discussed with respect to Figure 4.

For example, when the three-phase inverter power module 40 according to the exemplary embodiment of Figures 5 and 6 is operated so that a commutation in a single phase takes place, a commutation loop is formed. This commutation loop of that phase comprises three pairs of positive DC terminals and three pairs of negative DC terminals, i.e., one pair for each of the half-bridge subunits 13, 19, 23 comprised in each of the six-pack submodules 28, 29, 30. For example, there are three pairs of parallel terminals, so that a terminal inductance is reduced to one third from an original terminal inductance, i.e. in a conventional solution. In this case, the stray inductances of the positive DC terminals and the negative DC terminals are relevant.

Exemplarily, a commutation of a first AC phase involves the first half-bridge subunit 13 of the first six-pack submodule 28, the first half-bridge subunit 13 of the second six-pack submodule 29 and the first half-bridge subunit 13 of the third six-pack submodule 30. Exemplarily, a commutation of a second AC phase involves the second half-bridge subunit 19 of the first six-pack submodule 28, the second half-bridge subunit 19 of the second six-pack submodule 29 and the second half-bridge subunit 19 of the third six-pack submodule 30. This can be applied respectively for a commutation of a third AC phase.

Thereby, exemplarily, a process of providing connections to the respective external terminals may be simplified and a wiring effort may be minimized for a user of the three-phase inverter power module. For example, the internal wiring/interconnection of the module may be more difficult, however the external wiring for the user may be easier.

The commutation loop of one phase thus involves three pairs of positive DC terminals and negative DC terminals in parallel. Therefore, a terminal inductance contributing to a commutation loop inductance is reduced to one third due to the use of the three parallel terminals, in contrast to the commutation loop as discussed with respect to Figure 3. A reduction of a stray inductance is only valid, if the three half-bridge subunits involved in the commutation of that phase are not commutating simultaneously. When controlling switches of the respective half-bridge subunits, this must be ensured.

For example, in a low-inductance set-up, the terminal inductance, i.e., the stray inductance of the respective positive DC terminals and the respective negative DC terminals, typically contributes to 30 percent of a total inductance of the commutation loop. If the terminal inductance may be reduced to one third, and thus to 10 percent of the total inductance, this total inductance is relatively reduced from 100 percent to 80 percent. In this way, a 20 percent reduction of the total inductance of the commutation loop can be achieved.

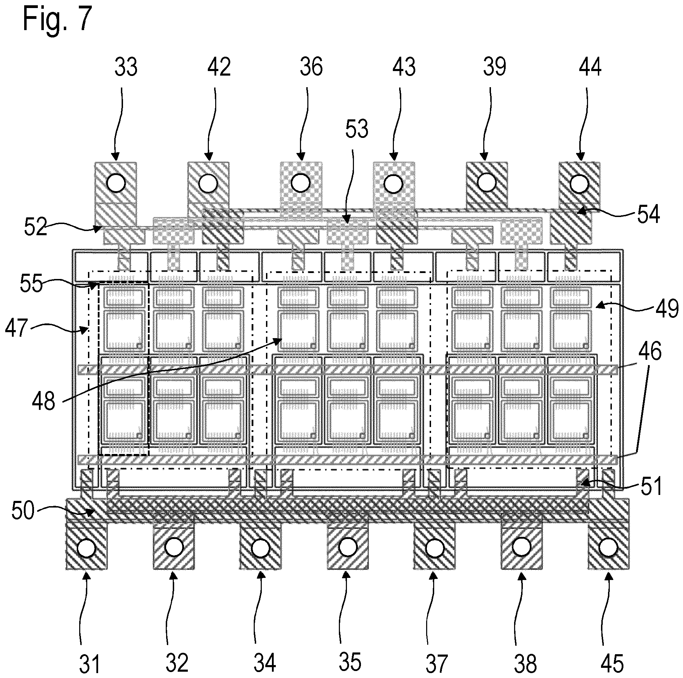

The layout of the three-phase inverter power module 40 according to the exemplary embodiment of Figure 7 comprises the three-phase inverter power module 40 as discussed with respect to Figure 6.

According to the exemplary embodiment, the three-phase inverter power module 40 further comprises another external positive DC terminal 45. The external positive DC terminals 31, 34, 37, 45 of the three-phase inverter power module 40 are connected by the positive DC bus bar 50. The external negative DC terminals 32, 35, 38 of the three-phase inverter power module 40 are connected by a negative DC bus bar 51.

The external AC terminals 33, 42 of the three-phase inverter power module 40 are connected to the respective internal AC terminals of the six-pack submodules 28, 29, 30 by the first AC bus bar 52. The external AC terminals 36, 43 of the three-phase inverter power module 40 are connected to the respective internal AC terminals of the six-pack submodules 28, 29, 30 by the second AC bus bar 53. The external AC terminals 39, 44 of the three-phase inverter power module 40 are connected to the respective internal AC terminals of the six-pack submodules 28, 29, 30 by the third AC bus bar 54. In this case, the three AC bus bars 52, 53, 54 may also be denoted as internal connections of the three-phase inverter power module 40.

Therefore, for example, the three-phase inverter power module 40 comprises at least j external negative DC terminals and j+1 external positive DC terminals, wherein j is an integer and j >= 1. According to Figure 7, j has a value of three. In this way, the three-phase inverter power module 40 may be provided in a symmetrical structure for the different AC phases may be provided. This symmetrical structure is advantageous for a reduction of the stray inductance.

Alternatively, the three-phase inverter power module 40 may comprise at least k external positive DC terminals 31, 34, 37, 45 and k+1 external negative DC terminals 32, 35, 38, wherein k is an integer and k >= 1.

According to the exemplary embodiment, the external positive DC terminals 31, 34, 37, 45 and the external negative DC terminals 32, 35, 38 are provided on a first lateral side of the three-phase inverter power module 40 and the external AC terminals 33, 36, 39, 42, 43, 44 are provided on a second lateral side of the three-phase inverter power module 40, wherein the second lateral side is opposite the first lateral side.

According to the exemplary embodiment, the three-phase inverter power module 40 further comprises a multi-layer printed circuit board, PCB, 46. The multi-layer PCB 46 may also be denoted as control signal PCB.

For example, the three-phase inverter power module 40 may further comprise a control terminal, which is not depicted in Figure 7, which is configured to obtain signals for controlling the switches of the half-bridges of the six-pack submodules comprised in the three-phase inverter power module 40.

According to the exemplary embodiment, the three-phase inverter power module 40 further comprises a first group of chips 47, a second group of chips 48 and a third group of chips 49. The first group of chips 47 comprises all three phases of the first six-pack submodule 28, i.e., the first phase chips 55 of the first group of chips 47. The second group of chips 48 comprises all three phases of the second six-pack submodule 29. The third group of chips 49 comprises all three phases of the third six-pack submodule 30. The three phases of the respective group of chips are arranged in parallel. Each group of chips may be mounted to a substrate forming a submodule.

The multi-layer PCB 46, exemplarily, comprises two or more layers, and the multi-layer PCB 46 may be electrically connected to the control terminal. The control terminal is provided on a third lateral side of the three-phase inverter power module 40 such as a right side, next to the third group of chips 49, or a left side, next to the first group of chips 47. Alternatively, the control terminal may be positioned on any arbitrary side of the three-phase inverter power module 40.

With regard to the foregoing description, a module which is comprised in a further module may be denoted as a submodule of that module. For example, such a submodule is not an individual module. Accordingly, a terminal of the module which is comprised in the further module may be denoted as connection or internal connection or internal terminal.

### Reference signs list

1 half-bridge module
2 first leg
3 second leg
4 first switch
5 first free wheeling diode
6 first switch terminal
7 second switch
8 second free wheeling diode
9 second switch terminal
10 positive direct current, DC, terminal
11 negative DC terminal
12 alternating current, AC, terminal
13 first half-bridge module
14 first positive DC terminal
15 first negative DC terminal
16 first AC terminal
17 first inductance
18 second inductance
19 second half-bridge module
20 second positive DC terminal
21 second negative DC terminal
22 second AC terminal
23 third half-bridge module
24 third positive DC terminal
25 third negative DC terminal
26 third AC terminal
27 six-pack module
28 first six-pack module
29 second six-pack module
30 third six-pack module
31 external fourth positive DC terminal
32 external fourth negative DC terminal
33 external fourth AC terminal
34 external fifth positive DC terminal
35 external fifth negative DC terminal
36 external fifth AC terminal
37 external sixth positive DC terminal
38 external sixth negative DC terminal
39 external sixth AC terminal
40 three-phase inverter power module
41 AC connections
42 another external first AC terminal
43 another external second AC terminal
44 another external third AC terminal
45 another external positive DC terminal
46 multi-layer printed circuit board, PCB
47 first group of chips
48 second group of chips
49 third group of chips
50 positive DC bus bar
51 negative DC bus bar
52 first AC bus bar
53 second AC bus bar
54 third AC bus bar
55 first phase chips

## Claims

1. A three-phase inverter power module (40) comprising at least two separated six-pack submodules (28, 29, 30), wherein:
- each six-pack submodule (28, 29, 30) comprises at least one half-bridge subunit (1) per phase,
- each half-bridge subunit (1) comprises an internal positive direct current, DC, terminal (10), an internal negative DC terminal (11) and an internal alternating current, AC, terminal (12), and
- the separated six-pack submodules (28, 29, 30) are electrically coupled with each other in parallel.

2. The three-phase inverter power module (40) according to claim 1, comprising:
- one or more external positive DC terminals (31, 34, 37) electrically coupled with the respective internal positive DC terminals (14, 20, 24) of all separated half-bridge subunits (13, 19, 27), and
- one or more external negative DC terminals (32, 35, 38) electrically coupled with the respective internal negative DC terminals (15, 21, 25) of all separated half-bridge subunits (13, 19, 27).

3. The three-phase inverter power module (40) according to any of the preceding claims, comprising at least one external AC terminal (33, 36, 39) per phase, which is electrically coupled with the respective internal AC terminals of all separated half-bridge subunits of the respective phase.

4. The three-phase inverter power module (40) according to claims 2 to 3, comprising at least two external positive DC terminals (31, 34, 37).

5. The three-phase inverter power module (40) according to claims 2 to 4, comprising at least two external negative DC terminals (32, 35, 38).

6. The three-phase inverter power module (40) according to claims 2 to 5, comprising at least k external positive DC terminals and k+1 external negative DC terminals, wherein k is an integer and k >= 1.

7. The three-phase inverter power module (40) according to claims 2 to 5, comprising at least j external negative DC terminals (32, 35, 38) and j+1 external positive DC terminals (31, 34, 37, 45), wherein j is an integer and j >= 1.

8. The three-phase inverter power module (40) according to any of the preceding claims, wherein the external positive DC terminals (31, 34, 37) and the external negative DC terminals (32, 35, 38) are provided on a first lateral side of the three-phase inverter power module (40) and the external AC terminals (33, 36, 39) are provided on a second lateral side of the three-phase inverter power module (40).

9. The three-phase inverter power module (40) according to any of the preceding claims, comprising at least three separated six-pack submodules (28, 29, 30).

10. The three-phase inverter power module (40) according to any of the preceding claims, wherein each half-bridge subunit (1) comprises two semiconductor chips formed as switches (4, 7), and the three-phase inverter power module (40) comprises a control terminal, which is configured to obtain signals for controlling the switches (4, 7) of the half-bridge subunits (1) .

11. The three-phase inverter power module (40) according to claim 10, comprising a multi-layer printed circuit board, PCB, (46) wherein the multi-layer PCB (46) comprises two or more layers, and the multi-layer PCB (46) is electrically connected to the control terminal.

12. The three-phase inverter power module (40) according to any of the preceding claims, wherein the control terminal is provided on a third lateral side of the three-phase inverter power module (40).

13. The three-phase inverter power module (40) according to any of the preceding claims, comprising at least two parallel substrates, wherein each substrate comprises all three phases of the respective six-pack submodule, wherein the three phases of the respective substrate are arranged in parallel.

14. The three-phase inverter power module (40) according to claims 1 to 12, comprising at least two groups of chips (47, 48, 49), wherein each group of chips (47, 48, 49) comprises all three phases of the respective six-pack submodule, wherein the three phases of the respective group of chips are arranged in parallel.

15. The three-phase inverter power module (40) according to any of the preceding claims, comprising a housing.
